# EUROPÄISCHE PATENTSCHRIFT

(11) **EP 0 350 752 B1**
(45) Veröffentlichungstag und Bekanntmachung des Hinweises auf die Patenterteilung: **13.10.1993**
(21) Anmeldenummer: 89112113.9
(22) Anmeldetag: 03.07.1989
(51) Int. Cl.: H01L 21/00

(54) **Haltevorrichtung für eine Scheibe sowie Anwendung derselben**
Holding device for a disc and its use
Dispositif de support pour un disque ainsi que son application

(30) Priorität: 15.07.1988 CH 2722/88
(43) Veröffentlichungstag der Anmeldung: 17.01.1990
(73) Patentinhaber: BALZERS AKTIENGESELLSCHAFT, 9496 Balzers (LI)
(72) Erfinder: Moll, Eberhard, Dr., FL-9488 Schellenberg (LI); Zanardo, Renzo, FL-9496 Balzers (LI)
(74) Vertreter: Troesch, Jacques J., Dr. sc. nat.

(56) Entgegenhaltungen:
- IBM TECHNICAL DISCLOSURE BULLETIN. vol. 18, no. 6, 26 November 1975, NEW YORK US Seiten 1836 - 1837; H. Von Burg: "ORIENTING BERNOUILLI EFFECT WAFER TRANSFER MECHANISM"

## Beschreibung

Die vorliegende Erfindung betrifft eine Haltevorrichtung für eine Scheibe nach dem Oberbegriff von Anspruch 1 und ihre Anwendung nach Anspruch 13.

Die Bearbeitung von Scheiben, z.B. von Siliziumscheiben für die Halbleiterfabrikation oder von Scheiben für die Fabrikation von Speicherplatten, erfolgt mehr und mehr in sogenannten Inline-Anlagen, bei denen jeweils nur eine Scheibe in den verschiedenen ProzessStationen bearbeitet wird. Jede einzelne Scheibe wird dabei von Prozess-Station zu Prozess-Station transportiert und dort auf einer Unterlage abgelegt. Normalerweise erfolgt der Transport bei horizontal liegender Scheibe. Für eine Bearbeitung der Scheibe in anderer, z.B. vertikaler Lage wird meist die Unterlage mit der darauf festgehaltenen Scheibe in der Prozess-Station entsprechend geschwenkt.

Es gibt auch Anlagen, bei denen eine zu behandelnde Scheibe in horizontaler Lage auf einen Hubtisch gelegt und dann ohne besondere Haltevorrichtung in die Bearbeitungsstation transportiert wird. Dabei fehlt aber die für einen schnellen und trotzdem zuverlässigen Transport nötige formschlüssige Sicherung der Scheibe in einer definierten Lage.

In den meisten Anlagen werden die Scheiben während des Transports auf ihrer Unterlage irgendwie festgehalten, z.B. durch greiferartige Blattfedern, die auf dem Scheibenrand aufliegen.

So ist aus der US-A-4 306 731 eine Haltevorrichtung für eine Scheibe auf einer Unterlage in Vertikalposition bekannt, bei der ein entfernbar fixierter Rahmen mittels dreier getrieben betätigbarer Haken auf die Scheibe eingreift. Mittels einer Transporteinrichtung wird die Unterlage für die Scheibe senkrecht zur Oeffnungsfläche besagten Rahmens bewegt und in eine Position gebracht, in welcher die getriebenen Haken auf die Scheibe eingreifen.

Nachteilig an dieser Haltevorrichtung ist:
- Sie ist aufgrund der vorgesehenen Antriebsorgane für die Haken aufwendig.
- Ein reibendes Eingreifen der Haken auf die Scheibe ist praktisch unvermeidlich.

Wenn es sich nämlich bei der Bearbeitung um eine Beschichtung handelt, z.B. eine Beschichtung mit 1µm Aluminium pro Scheibe bei einem Durchsatz von einer Scheibe pro Minute, so kann auf Halteorganen hierfür in fünf Tagen eine über 7mm starke Aluminiumschicht aufwachsen. Handelt es sich bei der Bearbeitung um einen Aetzprozess, so werden die Halteorgane mitgeätzt, und das von diesen abgetragene Material kann dabei die Scheibenoberfläche verunreinigen.

Der vorliegenden Erfindung liegt nun die Aufgabe zugrunde, eine universell verwendbare Haltevorrichtung der in Oberbegriff des Anspruchs 1 genannten Art zu konstruieren, welche die Scheibe beim Transport sichert und trotzdem die Probleme der bekannten Halteorgane vermeidet.

Diese Aufgabe wird durch die Ausbildung der Haltevorrichtung gemäss Anspruch 1 gelöst.

Eine Sichtverbindung auf unterhalb der Unterlage liegende Anlageteile kann von einer Bearbeitungsstation durch einen Spalt zwischen der Scheibe auf der Unterlage einerseits und einer ortsfesten Abdeckung anderseits entstehen. Eine gebräuchliche Methode, diesen Spalt zu schliessen, ist eine an der Unterlage befestigte und mit ihr transportierte, ringförmige Abschirmung, die von Zeit zu Zeit ausgewechselt werden muss.

Mit der erfindungsgemässen Haltevorrichtung wird dies gemäss Wortlaut von Anspruch 6 gelöst.

Bevorzugterweise wird der Rahmen als loses, frei austauschbares Teil vorgesehen, gemäss Wortlaut von Anspruch 5.

Es ist ein besonderer Vorteil der erfindungsgemässen Haltevorrichtung, dass die Scheibe, je nach Art der Bearbeitung, freiliegend oder mit Hilfe des erwähnten Rahmens gesichert bearbeitet werden kann. Dabei kann der an der Unterlage aufliegende Rahmen gegen einen solchen ausgetauscht werden, der auf der Scheibe selbst aufliegt. Man kann also dieselbe Haltevorrichtung in derselben Anlage für verschiedenartige Prozess-Stationen verwenden bzw. in derselben Prozess-Station den Bearbeitungsmodul, z.B. ein planares Magnetron, gegen ein anderes Modul, z.B. eine Aetzvorrichtung, austauschen und dabei in einem Fall eine freiliegende Scheibe, im anderen eine gesicherte Scheibe bearbeiten, indem man den Rahmen austauscht.

Die Sicherung der Scheibe mit den Rahmen kann derart erfolgen, dass, nach dem Wortlaut von Anspruch 7, nur wenige Haken die Scheibe berühren. In diesem Fall wird auch ein grosser Teil des Scheibenrands bearbeitet. Es kann aber auch interessant sein, den ganzen Rand zu berühren, z.B. um eine Dichtwirkung für ein Gaspolster zwischen der Scheibe und der Unterlage zu erzielen. Der Rahmen kann in diesem Fall mittels Federbalg gasdicht am Anlagengehäuse befestigt sein.

Solche Gaspolster nach dem Wortlaut von Anspruch 2 werden als Wärmeleitungsmittel zwischen der Scheibe und einer Heiz- bzw. Kühlplatte benützt. Der Druck des Gaspolsters erzeugt dabei eine Kraft, die durch ein grösseres Gewicht des Rahmens als Gegenkraft überwunden werden kann und die die Scheibe sanft an den Rahmen legt. Auch die Federwirkung eines Balges oder speziell dafür angebrachter Federn kann dazu benützt werden.

Durch den Aufbau nach Anspruch 9 wird die Unterlage von der Scheibe voll bedeckt.

Bei Halbleiterscheiben für die Herstellung integrierter Mikroelektronik-Bausteine muss die Unterlage auch die von der Kreisform abweichenden Konturen aufweisen, z.B. die zur Kennzeichnung der Kristallorientierung abgeschnittenen Segmente. Letztere sind auch der Grund für die Notwendigkeit, die Scheiben orientiert zu halten.

Bei einer Ausführungsform der erfindungsgemässen Haltevorrichtung nach Anspruch 3 werden Abweichungen von der genauen Orientierung der Scheibe korrigiert.

Durch den Transport der Scheibe wird sie gegen den Rahmen angelegt und dieser wird, in einer Ausführungsvariante, mit der Scheibe angehoben, so dass sich der Rahmen mit seinem Gewicht auf der Scheibe abstützt und letztere so haltert, gemäss Anspruch 4.

Ist anderseits an der Unterlage eine Gaszuführung zur Erzeugung eines Gaspolsters zwischen der Unterlage und der Scheibe gemäss Anspruch 2 vorgesehen, so kann der Rahmen stationär bleiben, und es wird die Federwirkung des Gaspolsters ausgenützt, um die Scheibe sanft und mit allenfalls einstellbarer Kraft gegen den Rahmen anzulegen.

In jedem Fall entstehen dabei zwischen Scheibe und Rahmen Kräfte, die parallel zur Flächennormalen der Scheibe stehen. Durch Vorsehen von Positionier- und/oder Orientierungsanordnungen am Rahmen werden gemäss besagten Anspruch 3 diese Kräfte ausgenützt, um, beispielsweise durch Führungsflächen, die Scheiben, sofern nötig, in die exakte Bearbeitungsposition zu bringen oder sie gar von einer vorgängig eingesetzten Bearbeitungsposition für eine nächste Bearbeitung mit dem zuletzt auferlegten Rahmen entsprechend in eine neue Bearbeitungsposition zu bringen. Unter Zuhilfenahme des allenfalls in seinem Druck einstellbaren Gaspolsters gelingt es, die empfindliche Scheibe nur äusserst sanft zu belasten und sie trotzdem in definierte Position zu bringen bzw. dort zu halten.

Die Erfindung wird anschliessend beispielsweise anhand von Figuren erläutert.

Es zeigen:
- Fig. 1: eine erfindungsgemässe Haltevorrichtung in der Ladeposition,
- Fig. 2: die Haltevorrichtung in einer Zwischenposition,
- Fig. 3: die Haltevorrichtung in Bearbeitungsposition,
- Fig. 4: eine Sicht von oben auf die Scheiben, den Halterahmen und die Halteorgane,
- Fig. 5: schematisch einen erfindungsgemässen Halterahmen zur Halterung der Scheibe in Bearbeitungsposition, bei die Arbeitsposition noch nicht einnehmender Scheibe (Fig. 5a) und die Bearbeitungsposition einnehmender Scheibe (Fig. 5b),
- Fig. 6: schematisch eine Teilansicht eines Halterahmens für die Scheibe in Bearbeitungsposition mit beispielsweise als Führungsflächen ausgebildeten Positionier- und/oder Orientierungsorganen.

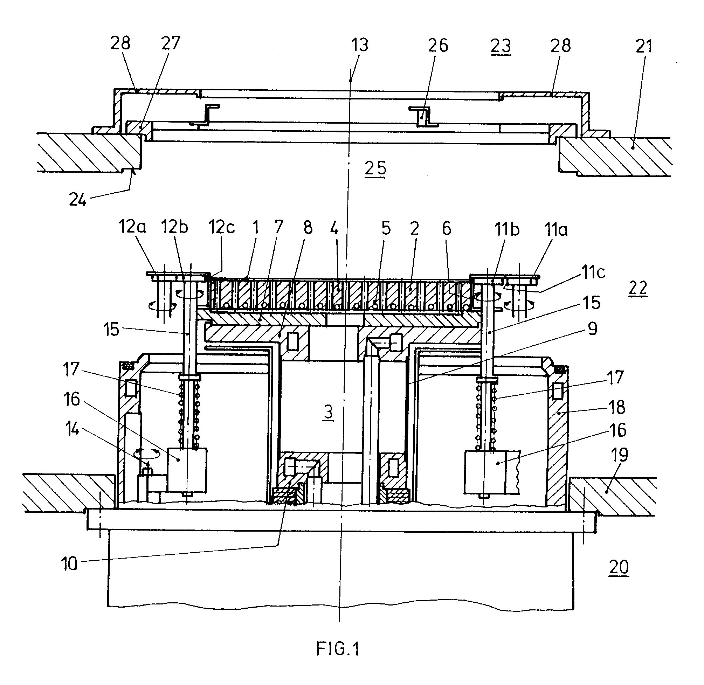

In Fig. 1 ist die Situation nach dem Ablegen einer Scheibe 1 auf eine Unterlage 2 in Ladeposition dargestellt. Die Unterlage 2 ist in diesem Fall mit einer Heizplatte 4 ausgerüstet. Sie weist Bohrungen auf, durch welche ein Gas zwischen die Scheibe 1 und die Heizplatte 4 gelangen kann. Ein Heizelement 5 kann die Heizplatte 4 auf Temperaturen bis über 500°C bringen. Diese Temperatur wird über das Gas als Wärmeleitungsmittel auf die Scheibe 1 übertragen. Meist wird dasselbe Gas verwendet wie beim Prozess, da sich eine Abdichtung entlang des Unterlagenrandes 6 nur mehr oder weniger gut verwirklichen lässt. Ein Flansch 7 dient zur Befestigung der Heizelemente 5 und zur Gaszufuhr für die Bohrungen der Heizplatte 4. Diese und der Flansch 7 sind zusammen auf einem Durchführungsmodul befestigt, bestehend aus einem Flansch 8 mit Schnellkühleinrichtung, der seinerseits über ein dünnes Rohr 9 wärmeisolierend mit einem gekühlten, elektrisch isoliert befestigten Bauteil 10 gasdicht verbunden ist.

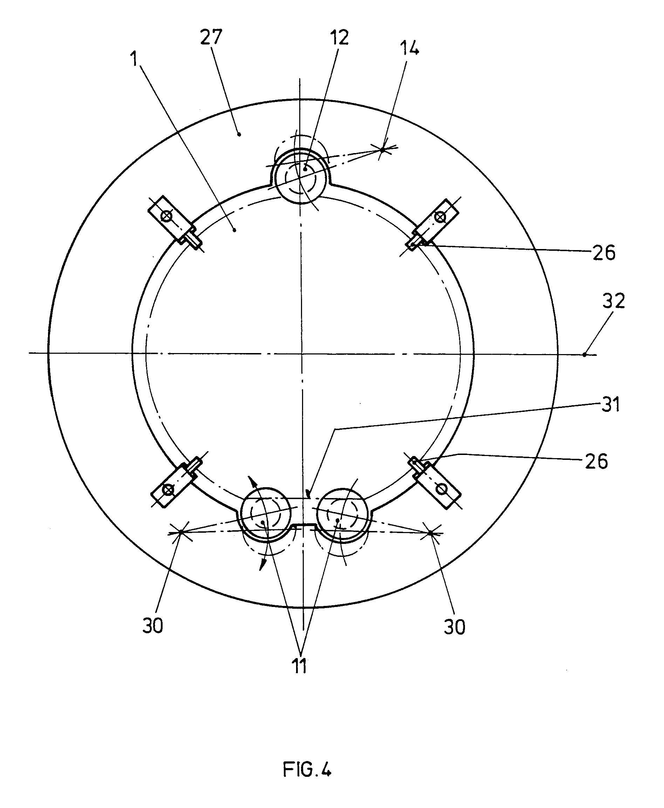

Die am Scheibenrand angreifenden Halteorgane 11 und das gegenhaltende Halteorgan 12 bewegen sich nach dem Ablegen der Scheibe 1 auf der Unterlage 2 von der Stellung "offen" - 11a und 12a in Fig. 1 - in die Stellung "geschlossen" - 11b und 12b in Fig. 1 -. Sie werden dazu um eine zur Scheibennormalen 13 parallele Achse 14 geschwenkt. Bei dieser Bewegung wird die Position und/oder Orientierung der Scheibe durch Angreifen von Flächen 11c, 12c an den Rand der Scheibe 1 korrigiert, ein Vorgang, der im speziellen weiter unten anhand der Fig. 4 erläutert wird. Die Halteorgane weisen Antriebsanker 15 auf, die in Lagern 16 um jeweilige Achsen drehbar gelagert sind. Die Anker 15 bestehen aus zwei teleskopartig ineinandergesteckten Teilen, die sich gegen die Kraft einer Schraubenfeder 17 zusamenschieben lassen.

Ein in diesem Beispiel topfförmiger Ventilteller 18 dient als Montagebasis für die Halteorgane mit ihrer Bewegungsmechanik und für die Unterlage 2. Er bildet zusammen mit diesen Teilen eine angetriebene Hubeinrichtung 3 für die Scheibe 1. Diese ist bezüglich einer Aussenwand 19 eines Vakuumbehälters beweglich. Als Abdichtung gegen die Atmosphäre 20 dienen in Fig. 1 nicht sichtbare metallische Faltenbeläge. Eine Wand 21 trennt eine Transportkammer 22 von der Bearbeitungskammer 23, die beide als Vakuumrezipienten ausgebildet sind. Die Wand 21 ist im Bereich 24, um eine Durchführöffnung 25, als Ventilsitz für den Ventilteller 18 ausgestaltet. Ein mit Haken 26 versehener beweglicher Rahmen 27 liegt in der Oeffnung 25 positioniert frei auf der Wand 21 auf, während eine Abdeckung 28 fest, bei Wartungsarbeiten leicht lösbar, mit der Wand 21 verbunden ist.

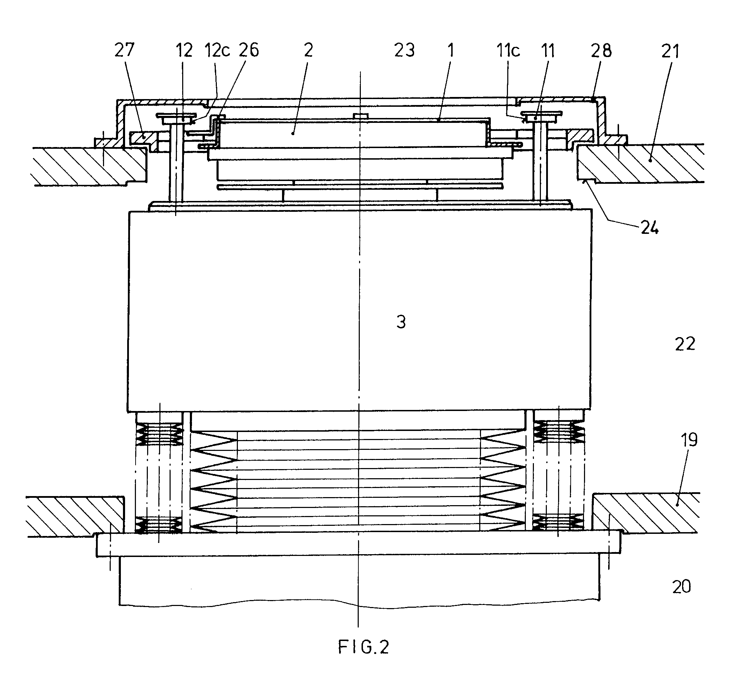

Fig. 2 zeigt die Haltevorrichtung, nachdem die Unterlage 2 mit der Scheibe 1 in eine Zwischenposition gefahren ist und kurz zuvor den beweglichen Halterahmen 27 an den Haken 26 berührt und etwas angehoben hat. Der Halterahmen 27 hängt nun an der Scheibe 1, drückt sie gegen die Unterlage 2 und sichert sie so gegen seitliches Verrutschen. Die Halteorgane 11 und 12 sind nach ihrer in der Zwischenposition ausgeführten Schwenkbewegung - getrieben durch einen (nicht dargestellten), mit dem Hubantrieb synchronisierten Halteorgan-Antrieb - in die Stellung "offen" bewegt.

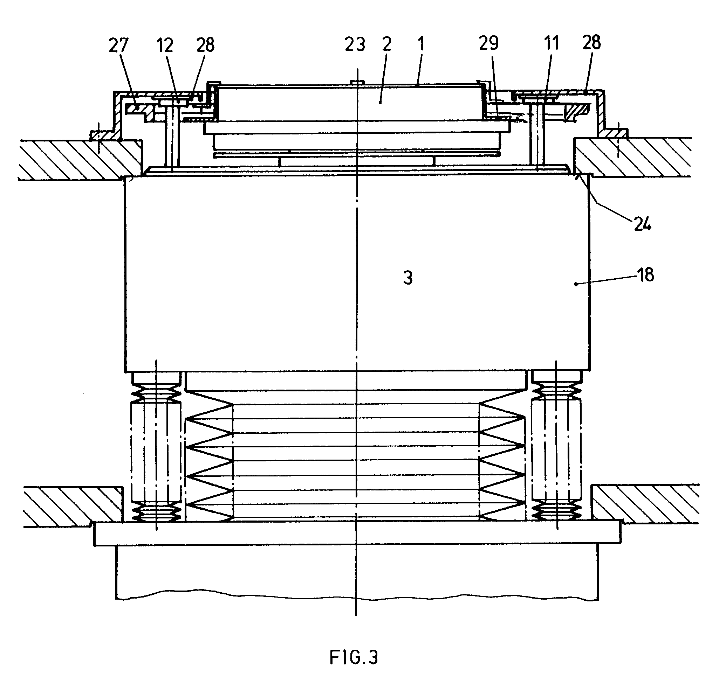

Fig. 3 zeigt die Haltevorrichtung in der Bearbeitungsposition. Sie ist mechanisch durch den Anschlag des Ventiltellers 18 an den Ventilsitz 24 definiert. Die Scheibe 1 ragt in die Bearbeitungskammer hinein und ist der Bearbeitung voll ausgesetzt, während die Halteorgane 11 und 12 gegen die Abdeckung 28 gedrückt und dabei federnd zusamengeschoben sind.

Fig. 3 zeigt wiederum den beweglichen Halterahmen 27. Die Scheibe 1 liegt hier frei auf der Unterlage 2, ohne Heizplatte. Zum Schutz der Teile unterhalb der Abdeckung 28 ist ein Abschirmrahmen 29 an der Unterlage angebracht. Er hat z.B. die Form einer Rinne. Er muss bei Beschichtungsprozessen Platz für dicke Beläge bieten, z.B. für bis zu 7mm Aluminium. Auch auf der Abdeckung 28 können Schichten dieser Dicke aufwachsen. Sie ist deshalb von der Bearbeitungskammer 23 her leicht auswechselbar, ebenso wie der bewegliche Halterahmen 27 bzw. der Abschirmrahmen 29.

Fig. 4 zeigt den beweglichen Halterahmen 27 mit Haken 26 und die Halteorgane 11 und 12 im formschlüssigen Kontakt mit der Scheibe 1, von der Bearbeitungskammer 23 her gesehen, wenn man die Abdeckung 28 entfernt. Es ist die Situation nach Ankunft der Unterlage in der Zwischenposition, jedoch vor dem Auswärtsschwenken der Halteorgane gezeigt. Sie ist identisch mit der Situation in der Ladeposition nach dem Einschwenken der Halteorgane in die Stellung "geschlossen". Der Rahmen 27 liegt in einer Ebene oberhalb der Scheibe 1 und der Halteorgane 11, 12. Die beiden Situationen wiederholen sich beim Rücktransport von der Bearbeitungsposition zur Ladeposition. Zweimal bei jedem Bearbeitungszyklus mit Hin- und Rücktransport, nämlich jeweils beim Einschwenken der Halteorgane in die Stellung "geschlossen", werden die Scheibenorientierung (azimutale Position) und/oder -position korrigiert. Dabei werden zuerst die Halteorgane 11 um die Achsen 30 geschwenkt und hart an einen mechanischen Bezugsanschlag (nicht dargestellt) gedrückt. Dann wird das Halteorgan 12 um die Achse 14 nach innen geschwenkt. Es drückt die Scheibe 1 mit dem Segment (oder Flat) 31 weich gegen die Halteorgane 11 und korrigiert dabei die Scheibenorientierung und/oder -position, wenn die Halteorgane 11 vom Segment 31 nicht gleichzeitig berührt werden, d.h. wenn die Halteorgane 11 und der Abschnitt 31 nicht von vornherein parallel sind. Eine Verschiebung der Scheibe in Richtung der Achse 32 durch den Vorgang der Orientierungskorrektur kann in beiden Positionen begrenzt werden, in der Ladeposition durch das hier nicht beschriebene Mittel für den Scheibentransport von Station zu Station, in der Zwischenposition durch den Rahmen 27 oder daran befestigte Teile.

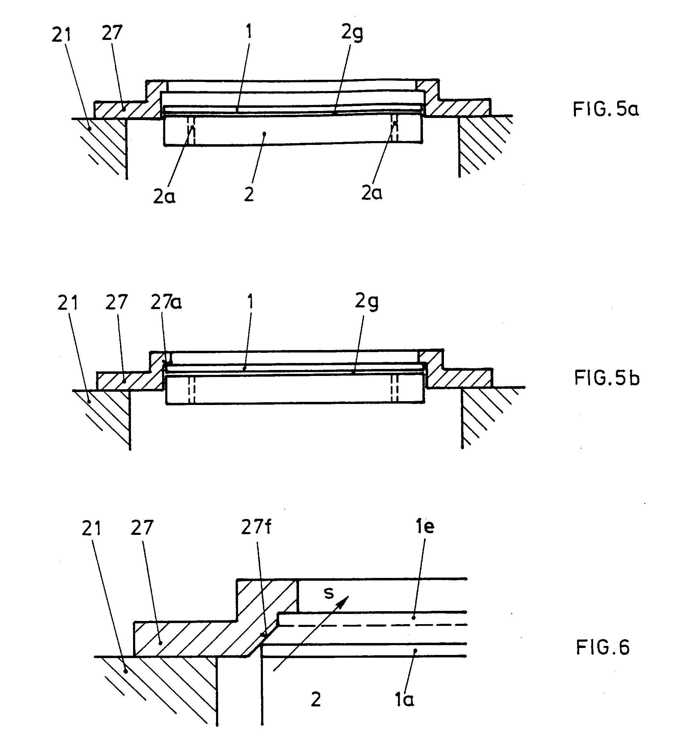

In den Fig. 5 und 6 ist schematisch die Scheibe 1 in Bearbeitungsposition dargestellt, mit dem Haltering 27 als Fixations- bzw. Positionsorgan für die Scheibe in dieser Position. Gemäss Fig. 5a ist die Unterlage 2 mit der Scheibe 1 unmittelbar vor Erreichen der Bearbeitungsposition dargestellt. Mit Hilfe der schematisch dargestellten Gaszufuhren 2a wird zwischen der Scheibe 1 und der Unterlage 2 ein, wie bereits erläutert wurde, die Wärmeleitung und den Wärmeübergang verbesserndes Gaskissen 2g erzeugt, welches die Scheibe 1 wenig anhebt, in einem in den Figuren bei weiten übertrieben dargestellten, geringen Ausmass. Bei Weiterheben der Scheibe 1 mit Hilfe der getriebenen Unterlage 2, gemäss Fig. 5b, tritt nun die Scheibe 1 peripher mit den Flanken des Halteringes 27 in Kontakt und wird durch die Druckdifferenz des allenfalls gesteuerten Gasdruckes im Gaskissen 2g und dem Umgebungsdruck in der Bearbeitungskammer gegen die Halteflanke 27a des Halteringes 27 gepresst. Bei dieser Ausführungsvariante verbleibt der Haltering 27 abgestützt am Teil 21, und die Scheibe 1 wird lediglich durch die erwähnte, allenfalls einstellbare Gasdruckdifferenz und die entsprechenden Kräfte an die Flanke 27a dieses Ringes angelegt.

In Fig. 6 ist ein Ausschnitt einer Darstellung gemäss den Fig. 5 dargestellt. Um die Scheibe 1 nötigenfalls zu orientieren, d.h. azimutal auszurichten und/oder zu positionieren, d.h. in einer translatorischen Bewegung in ihre SOLL-Position zu bringen, können an den Innenflanken des Halteringes 27 Führungsorgane, wie Leitflächen 27, vorgesehen sein. Bei Vergrösserung des Auflagedruckes zwischen der Scheibe 1 in der zuerst eingenommenen Position 1a gegen die Flanke 27f verschiebt sich die Scheibe 1 sanft gegen ihre SOLL-Position, wie mit dem Pfeil s dargestellt, und nimmt schliesslich die gestrichelt in Fig. 6 dargestellte und mit 1e bezeichnete Position ein.

Hiermit wirkt der Haltering, losgelöst vom Vorsehen der Halteorgane, wie sie anhand der Fig. 1 bis 4 beschrieben wurden, als Halte- und Positionierorgane für die Scheibe 1 in Bearbeitungsposition und kann ohne weiteres ausgewechselt werden.

## Patentansprüche

1. Haltevorrichtung für eine Scheibe in Position auf einer Unterlage für ihre Bearbeitung in Vakuum, mit einen die Scheibe mindestens an drei Bereichen überkragenden Rahmen sowie einer Abstützung für den Rahmen, wobei eine Transporteinrichtung zum Bewegen der Unterlage senkrecht zur Oeffnungsfläche des Rahmens und zum in Eingriffbringen des Rahmens auf die Scheibe vorgesehen ist, dadurch gekennzeichnet, dass die Abstützung für den Rahmen (27) als Abstützfläche ausgebildet ist, wovon der Rahmen abgehoben werden kann, und das in Eingriffbringen durch Anlegen der Scheibe (1) mittels der getriebenen Unterlage (2) an den Rahmen (27) erfolgt.

2. Haltevorrichtung nach Anspruch 1, dadurch gekennzeichnet, dass die Unterlage (2) mindestens eine Gaszuführung (2a) zur Erzeugung eines Gaspolsters (2g) zwischen ihr und der Scheibe (1) aufweist, einerseits zur Erhöhung der Wärmeleitung zwischen Unterlage und Scheibe, anderseits, um die Scheibe (1) sanft, vorzugsweise einstellbar an den Rahmen (27) zu legen.

3. Haltevorrichtung nach einem der Ansprüche 1 oder 2, dadurch gekennzeichnet, dass am Rahmen (27) eine Positionieranordnung (27f), wie Führungsflächen für die Scheibe vorgesehen sind, um bei Abweichung der Scheibenposition und/oder Orientierung von einer vorgegebenen Position und/oder Orientierung letztere (1) bei Anlegen an den Rahmen in die vorgegebene Position und/oder Orientierung zu rücken.

4. Haltevorrichtung nach einem der Ansprüche 1 bis 3, dadurch gekennzeichnet, dass der Rahmen in Richtung zur Bearbeitungsposition für die Scheibe frei beweglich ist, derart, dass er sich mit seinem Eigengewicht auf der Scheibe (1) abstützt.

5. Haltevorrichtung nach einem der Ansprüche 1 bis 4, dadurch gekennzeichnet, dass der Rahmen ein loses, frei austauschbares Teil ist.

6. Haltevorrichtung nach einem der Ansprüche 1 bis 5, dadurch gekennzeichnet, dass der Rahmen einen Spalt zwischen Scheibe (1) und Unterlage (2) einerseits und einer ortsfesten Abdeckung (28) um Scheibe (1) und Unterlage (2) herum bei Abheben von der Ablagefläche im wesentlichen verschliesst.

7. Haltevorrichtung nach einem der Ansprüche 1 bis 6, dadurch gekennzeichnet, dass der Rahmen (27) mindestens drei einragende Haken (26) als Abstützbereiche aufweist.

8. Haltevorrichtung nach Anspruch 2, dadurch gekennzeichnet, dass der Halterahmen (27) so ausgebildet ist, dass er ein seitliches Wegschwimmen der Scheibe (1) auf dem Gaspolster (2g) verhindert.

9. Haltevorrichtung nach Anspruch 6, dadurch gekennzeichnet, dass die Abdeckung (28) derart von der Unterlage (2) beabstandet ist, dass eine Scheibe (1), welche die Unterlage (2) überkragt, mit ihr bewegt werden kann.

10. Haltevorrichtung nach einem der Ansprüche 1 bis 9, dadurch gekennzeichnet, dass die Unterlage (2) in zu ihrer Auflagefläche normaler Richtung zum Auswechseln in eine Lagerung hierfür ein- und aussteckbar ist.

11. Haltevorrichtung nach einem der Ansprüche 1 bis 10, dadurch gekennzeichnet, dass mindestens die Auflagefläche der Unterlage (2) für die Scheibe (1) von übrigen Teilen elektrisch und/oder thermisch isoliert ist.

12. Haltevorrichtung nach einem der Ansprüche 1 bis 11, dadurch gekennzeichnet, dass die Unterlage (2) um eine zu ihrer Auflagefläche senkrechte Achse drehbar gelagert ist.

13. Anwendung der Haltevorrichtung nach einem der Ansprüche 1 bis 12 für Kreisscheiben für die Halbleiterfabrikation oder für Scheiben für die Speicherplattenherstellung.

## Claims

1. A holding device for holding a disc in position on a support for processing thereof in a vacuum, comprising a frame rich overhangs the disc at least at three regions, and a support means for the frame, wherein there is provided a transportation device for moving the support perpendicularly to the opening surface of the frame and for bringing the frame into engagement on to the disc, characterised in that the support bans for the frame (27) is in the form of a support surface from which the frame can be lifted, and the operation of bringing the frame into engagement on to the disc is effected by application of the disc (1) by bans of the driven support (2) against the frame (27).

2. A holding device according to claim 1 characterised in that the support (2) has at least one gas feed bans (2a) for producing a gas cushion (2g) between the support and the disc (1), on the one hand to increase the conduction of heat between the support and the disc and on the other hand to lay the disc (1) gently and preferably adjustably against the frame (27).

3. A holding device according to one of claims 1 and 2 characterised in that provided on the frame (27) are a positioning arrangement (27f) such as guide surfaces for the disc in order in the event of a departure of the disc position and/or orientation fro a predetermined position and/or orientation to eve the disc (1) upon being applied to the frame into the predetermined position and/or orientation.

4. A holding device according to one of claims 1 to 3 characterised in that the frame is freely movable in the direction towards the processing position for the disc, in such a way that it bears with its own weight on the disc (1).

5. A holding device according to one of claims 1 to 4 characterised in that the frame is a loose, freely interchangeable member.

6. A holding device according to one of claims 1 to 5 characterised in that the frame substantially closes a gap between the disc (1) and the support (2) on the one hand and a stationary cover means (28) around the disc (1) and the support (2) upon being lifted off the supporting surface.

7. A holding device according to one of claims 1 to 6 characterised in that the frame (27) has at least three inwardly projecting hooks (26) as support regions.

8. A holding device according to claim 2 characterised in that the holding frame (27) is of such a configuration that it prevents the disc (1) from floating laterally away on the gas cushion (2g).

9. A holding device according to claim 1 characterised in that the cover bans (28) is so spaced fro the support (2) that a disc (1) which overhangs the support (2) can be moved with same.

10. A holding device according to one of claims 1 to 9 characterised in that the support (2) can be fitted into and disengaged fro a bunting bans therefor in a direction normal to its support surface for replacement purposes.

11. A holding device according to one of claims 1 to 10 characterised in that at least the support surface of the support (2) for the disc (1) is electrically and/or thermally insulated from other parts.

12. A holding device according to one of claims 1 to 11 characterised in that the support (2) is mounted rotatably about an axis which is perpendicular to its support surface.

13. Use of the holding device according to one of claims 1 to 12 for circular discs for semiconductor manufacture or for discs for storage disc production.

## Revendications

1. Dispositif de maintien pour un disque placé sur un support pour son traitement sous vide, comportant un cadre débordant du disque en au moins trois zones ainsi qu'un élément d'appui pour le cadre, un dispositif de transport étant prévu pour déplacer le support dans un sens vertical par rapport à la surface d'ouverture du cadre et pour la mise en prise du cadre sur 1e disque, caractérisé en ce que l'élément d'appui du cadre (27) est conçu sous la forme d'une surface d'appui à partir de laquelle le cadre peut être soulevé, et en ce que la mise en prise est effectuée par l'application du disque (1) contre le cadre (27) au moyen du support propulsé (2).

2. Dispositif de maintien selon la revendication 1, caractérisé en ce que le support (2) comporte au moins une alimentation en gaz (2a) destinée à engendrer un coussin de gaz (2g) entre lui-même et le disque (1), d'une part pour augmenter la conduction thermique entre le support et le disque, d'autre part pour déposer le disque (1) en douceur contre le cadre (27), de préférence de façon réglable.

3. Dispositif de maintien selon l'une des revendications 1 ou 2, caractérisé en ce que sur le cadre (27) il est prévu un dispositif de positionnement (27f) ainsi que des surfaces de guidage pour le disque, afin de remettre ce dernier (1) dans la position et/ou l'orientation prédéterminée lors de l'application contre le cadre, dans le cas d'un écart de position et/ou d'orientation du disque par rapport à la position et/ou l'orientation prédéterminée.

4. Dispositif de maintien selon l'une quelconque des revendications 1 à 3, caractérisé en ce que le cadre est librement mobile en direction de la position de traitement du disque, de sorte qu'il prend appui sur le disque (1) sous l'effet de son propre poids.

5. Dispositif de maintien selon l'une des revendications 1 à 4, caractérisé en ce que le cadre est un élément mobile, librement interchangeable.

6. Dispositif de maintien selon l'une des revendications 1 à 5, caractérisé en ce que, lors de son soulèvement de la surface d'appui, le cadre obture pour l'essentiel une fente entre le disque (1) et le support (2) d'une part, et un recouvrement fixe (28) entourant le disque (1) et le support (2) d'autre part.

7. Dispositif de maintien selon l'une des revendications 1 à 6, caractérisé en ce que le cadre (27) comporte au moins trois crochets pénétrants (26) faisant office de zones d'appui.

8. Dispositif de maintien selon la revendication 2, caractérisé en ce que le cadre de maintien (27) est conçu de façon à éviter que le disque (1) puisse dévier latéralement en flottant sur le coussin de gaz (2g).

9. Dispositif de maintien selon la revendication 6, caractérisé en ce que le recouvrement (28) est situé à une distance telle du support (2) qu'un disque (1) débordant du support (2) peut être déplacé avec ce dernier.

10. Dispositif de maintien selon l'une des revendications 1 à 9, caractérisé en ce que, dans le but d'un échange pour mise en stock, le support (2) peut être emboîté et déboîté dans la direction normale par rapport à sa surface d'appui.

11. Dispositif de maintien selon l'une des revendications 1 à 10, caractérisé en ce qu'au moins la surface d'appui du support (2) pour le disque (1) est isolée électriquement et/ou thermiquement des autres éléments.

12. Dispositif de maintien selon l'une des revendications 1 à 11, caractérisé en ce que le support (2) est monté en rotation autour d'un axe perpendiculaire à sa surface d'appui.

13. Utilisation du dispositif de maintien selon l'une quelconque des revendications 1 à 12 pour des disques circulaires destinés à la fabrication de semi-conducteurs ou pour des disques destinés à la fabrication de cibles à mémoire.
